# EUROPEAN PATENT APPLICATION

(11) **EP 0 614 231 A2**
(43) Date of publication of application: **07.09.1994**
(21) Application number: 94103320.1
(22) Date of filing: 04.03.1994
(51) Int. Cl.: H01L 29/86, H01L 29/36

(54) **PN junction and method of manufacturing the same**

(30) Priority: 05.03.1993 JP 45143/93; 28.12.1993 JP 335386/93
(71) Applicant: MITSUBISHI DENKI KABUSHIKI KAISHA, Tokyo 100 (JP)
(72) Inventor: Soejima, Noriyuki, c/o Fukuryo Semicond. Eng. Corp, Fukuoka-shi, Fukuoka 819-01 (JP); Takata, Ikunori, c/o MITSUBISHI DENKI K.K., Itami-shi, Hyogo 664 (JP)
(74) Representative: KUHNEN, WACKER & PARTNER

(57) **Abstract**

A P diffused layer (12) has an impurity surface concentration ranging from 1 x 10¹⁵ cm⁻³ to 1 x 10¹⁷ cm⁻³ and a thickness ranging from 0.1 µm to 3.0 µm. Since the P diffused layer (12) has lower impurity surface concentration, an injection of minority carriers from the P diffused layer (12) to an N⁻ semiconductor substrate (11) during a forward operation is suppressed, so that reverse recovery electric charges decrease. Since the P diffused layer (12) is thinner, the reverse recovery electric charges further decrease and a forward voltage is reduced. A peak of a reverse recovery current becomes smaller as the reverse recovery electric charges decrease. In consequence, a soft recovery is achieved, to therefore decrease a surge voltage.

## Description

### BACKGROUND OF THE INVENTION

### Field of the Invention

The present invention relates in general to a semiconductor device which has a PN junction, and more particularly to improvements related to a decrease of reverse recovery electric charges in a high-speed switching diode and the like.

### Description of the Background Art

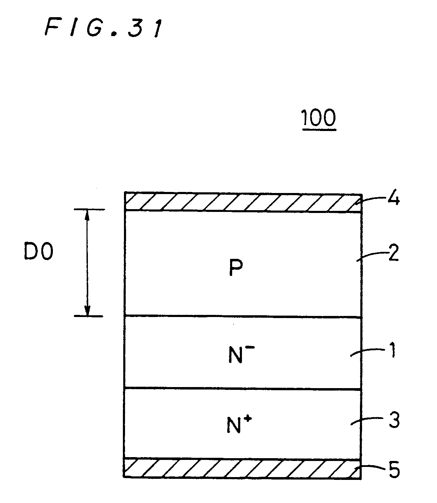

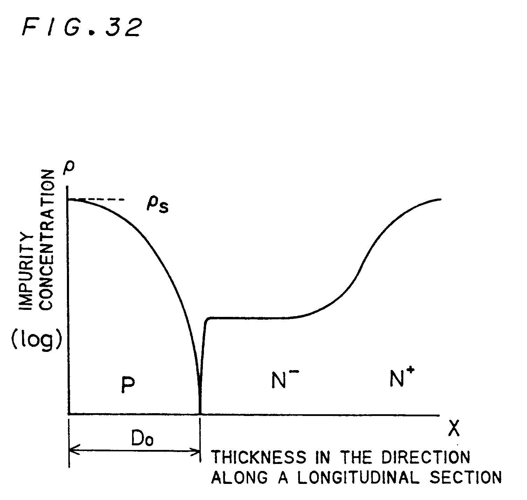

Fig. 31 is a sectional view showing a structure of a conventional high-speed switching diode 100 which has a PN junction. Fig. 32 is a schematic diagram showing a distribution of impurity concentration in the direction along a longitudinal section of the diode 100. This figure illustrates a relation between the thickness X in the direction along the longitudinal section and the impurity concentration ρ of the diode 100 in a semi-logarithmic scale.

The diode 100 comprises an N⁻ semiconductor substrate 1 of low impurity concentration, an N⁺ diffused layer 3 of high impurity concentration on the lower main surface of the N⁻ semiconductor substrate 1 and a P diffused layer 2 having an impurity concentration ρ s over 1 x 10¹⁷cm⁻³ in its surface and a thickness D0 over 20 µm on the upper main surface of the N⁻ semiconductor substrate 1.

The diode 100 further comprises a metal electrode layer 4 on the upper surface of the P diffused layer 2 and a metal electrode layer 5 on the lower surface of the N⁺ diffused layer 3. The metal electrode layers 4 and 5 are formed while being in ohmic contact with the P diffused layer 2 and the N⁺ diffused layer 3, respectively.

In order to decrease reverse recovery electric charges in a switching operation conducted by using the diode 100, it is required that the number of minority carriers accumulated in the P-type semiconductor layer 2 and N-type semiconductor layers 1 and 3, respectively, during a forward operation should be small. To meet the requirement, metals such as gold, platinum or the like have been diffused to act as lifetime killer in conventional arts. In this method, however, there is a disadvantage that a forward voltage remarkably increases as the reverse recovery electric charges decrease.

In order to suppress a surge voltage developed during a reverse recovery, it is necessary to achieve a soft recovery waveform of a reverse recovery current. To achieve the soil recovery waveform of the reverse recovery current, however, it is required that the number of minority carriers (positive holes) accumulated in a region in the vicinity of an interface of the N⁻ semiconductor substrate 1 and N⁺ diffused layer 3 during the forward operation, to which a depletion layer comes during the reverse recovery, should be large. This can be accomplished by decreasing the impurity concentration of the region in the vicinity of the interface.

On the other hand, in order to decrease the reverse recovery electric charges, the number of minority carriers (positive holes) accumulated in the region in the vicinity of the interface during the forward operation should be small. This can be accomplished by increasing the impurity concentration of the region in the vicinity of the interface.

Thus, a requirement of decreasing the reverse recovery electric charges and a requirement of achieving the soft recovery waveform are those opposite to each other. For this reason, depending on the use of the diode 100, these conditions should be balanced with each other to ensure an optimum distribution of impurity concentration in the region in the vicinity of the interface of the N⁻ semiconductor substrate 1 and the N⁺ diffused layer 3.

In the conventional arts, however, since the N⁺ diffused layer 3 is formed by diffusion, it is disadvantageously impossible to ensure free control over the distribution of the impurity concentration of the region in the vicinity of the interface.

### SUMMARY OF THE INVENTION

According to the present invention, a first semiconductor device comprises: (a) a first semiconductor layer of a first conductivity type including first and second main surfaces and having a first impurity concentration; (b) a second semiconductor layer of a second conductivity type provided on the first main surface of the first semiconductor layer; (c) a third semiconductor layer of the first conductivity type provided on the second main surface of the first semiconductor layer and having a second impurity concentration higher than the first impurity concentration; (d) a first electrode layer being in electric contact with the second semiconductor layer; and (e) a second electrode layer being in electric contact with the third semiconductor layer, and wherein an impurity concentration of the second semiconductor layer at a surface on the side of the first electrode layer is in the range of 1 x 10¹⁵ cm⁻³ to 1 x 10¹⁷ cm⁻³.

Preferably, a thickness of the second semiconductor layer is in the range of 0.1 µm to 3.0 µm.

In the first semiconductor device in accordance with the present invention, the impurity surface concentration of the second semiconductor layer which ranges from 1 x 10¹⁵ cm⁻³ to 1 x 10¹⁷ cm⁻³ makes it possible to suppress an injection of minority carriers from the second semiconductor layer to the first semiconductor layer during a forward operation, to thereby inhibit an unnecessary accumulation of electric charges. Hence, the reverse recovery electric charges decrease. In a case of impurity surface concentration of the second semiconductor layer which is over 1 x 10¹⁷ cm⁻³, the number of minority carries injected from the second semiconductor layer to the first semiconductor layer during the forward operation becomes considerably larger, resulting in a remarkable increase of the reverse recovery electric charges. Therefore, the impurity surface concentration of the second semiconductor layer should be 1 x 10¹⁷ cm⁻³ or under. Further, an effect of decreasing the reverse recovery electric charges becomes greater as the impurity surface concentration of the second semiconductor layer becomes lower. However, in a case of impurity surface concentration of the second semiconductor layer which is under 1 x 10¹⁵ cm⁻³, an ohmic contact existing between the first electrode layer and the second semiconductor layer is impaired, resulting in a remarkable increase of a forward voltage. Hence, the impurity surface concentration of the second semiconductor layer should be 1 x 10¹⁵ cm⁻³ or over.

Further preferably, the thickness of the second semiconductor layer is determined in the range of 0.1 µm to 3.0 µm, which is thinner as compared with that in the conventional art, so that it is possible to suppress an accumulation of minority carriers in the second semiconductor layer during the forward operation, to thereby inhibit an unnecessary accumulation of electric charges. In consequence, the reverse recovery charges further decrease. It also becomes possible to reduce the forward voltage which has been retained by a region having a thickness over 20 µm in conventional arts. Under the condition that the impurity surface concentration of the second semiconductor layer ranges from 1 x 10¹⁵ cm⁻³ to 1 x 10¹⁷ cm⁻³, a region for retaining the forward voltage is enlarged as the second semiconductor layer becomes thicker, and in particular, the forward voltage remarkably increases when the thickness is over 3.0 µm. Moreover, the number of minority carriers accumulated in the second semiconductor layer during the forward operation also becomes larger, resulting in a remarkable increase of the reverse recovery electric charges. Therefore, the thickness of the second semiconductor layer should be 3.0 µm or under. In this case, an effect of decreasing the forward voltage and the reverse recovery electric charges becomes greater as the second semiconductor layer becomes thinner. However, the thickness of the second semiconductor layer which is under 0.1 µm remarkably deteriorates manufacturing stability and reliability. Hence, the thickness of the second semiconductor layer should be 0.1 µm or over.

The second semiconductor layer which has both the impurity surface concentration ranging from 1 x 10¹⁵ cm⁻³ to 1 x 10¹⁷ cm⁻³ and the thickness ranging from 0.1 µm to 3.0 µm makes it possible to decrease the reverse recovery electric charges, and to make a peak of the reverse recovery current smaller. In consequence, a soft recovery is achieved, to thereby decrease the surge voltage. Thus, the second semiconductor layer which has both the impurity surface concentration ranging from 1 x 10¹⁵ cm⁻³ to 1 x 10¹⁷ cm⁻³ and the thickness ranging from 0.1 µm to 3.0 µm is deemed to be an optimum structure for decreasing the reverse recovery electric charges, suppressing an increase of the forward voltage with the decrease of the reverse recovery electric charges and achieving the soft recovery to thereby suppress the surge voltage. In this case, the impurity surface concentration and the thickness of the second semiconductor layer should be determined within the optimum ranges as mentioned above, respectively, depending on a withstand voltage required. The upper limits of the respective optimum ranges allow the withstand voltage in the kV range.

In a second semiconductor device in accordance with the first semiconductor device of the present invention, lattice defects are formed in an interface between the first semiconductor layer and the second semiconductor layer and a region in the vicinity thereof.

In the second semiconductor device, with the lattice defects which are formed in the interface of the first semiconductor layer and the second semiconductor layer and the region in the vicinity thereof, it is possible to further decrease the number of minority carriers injected from the second semiconductor layer to the first semiconductor layer during the forward operation and the number of minority carriers of reverse electric charges injected from the first semiconductor layer to the second semiconductor layer during the forward operation, while the second semiconductor layer retains the impurity surface concentration at the limit or over to keep in ohmic contact with the first electrode layer.

For this reason, functions to decrease the reverse recovery electric charges and to achieve the soft recovery work much better.

In a third semiconductor device in accordance with the first semiconductor device of the present invention, lattice defects are formed in an interface between the first semiconductor layer and the second semiconductor layer and a region in the vicinity thereof, regardless of the impurity surface concentration and the thickness of the second semiconductor layer.

With respect to the third semiconductor device, our attention is confined mainly to the characteristic feature that lattice defects are formed in an interface between the first semiconductor layer and the second semiconductor layer and a region in the vicinity thereof. The third semiconductor device makes it possible to decrease the number of minority carriers injected from the second semiconductor layer to the first semiconductor layer during the forward operation and the number of minority carriers of reverse electric charges injected from the first semiconductor layer to the second semiconductor layer during the forward operation. Accordingly, an effect of decreasing the reverse recovery electric charges can be enhanced and thus to achieve the soft recovery.

According to the present invention, a fourth semiconductor device comprises: (a) a first semiconductor layer of a first conductivity type including first and second main surfaces; (b) a second semiconductor layer of a second conductivity type provided on the first main surface of the first semiconductor layer; (c) a third semiconductor layer of the first conductivity type provided on the second main surface of the first semiconductor layer and having an impurity concentration higher than an impurity concentration of the first semiconductor layer; (d) a first electrode layer being in electric contact with the second semiconductor layer; and (e) a second electrode layer being in electric contact with the third semiconductor layer, and wherein the first semiconductor layer further includes: (a-1) a first epitaxial semiconductor layer being in electric contact with the second semiconductor layer and having an impurity concentration lower than the impurity concentration of the third semiconductor layer; and (a-2) a second epitaxial semiconductor layer provided between the first epitaxial semiconductor layer and the third semiconductor layer and having an impurity concentration higher than the impurity concentration of the first epitaxial semiconductor layer and lower than the impurity concentration of the third semiconductor layer.

In the fourth semiconductor device in accordance with the present invention, a plurality of epitaxial semiconductor layers having different impurity concentrations are employed as the first semiconductor layer. In consequence, it becomes easier to control a distribution of impurity concentration of a region in the vicinity of an interface between the first semiconductor layer and the third semiconductor layer by controlling the impurity concentration and thickness of the second epitaxial semiconductor layer, as compared with the case where the distribution of impurity concentration of the region in the vicinity of the interface between the first semiconductor layer and the third semiconductor layer is restricted due to diffusion since the third semiconductor layer is formed by diffusion on the second main surface of the first semiconductor layer. As the impurity concentration of the second epitaxial semiconductor layer becomes lower, the number of minority carriers accumulated in the second epitaxial semiconductor layer during the forward operation increases, resulting in a greater effect of achieving the soft recovery of the reverse recovery current. And also, as the second epitaxial semiconductor layer becomes thicker, the number of minority carriers accumulated in the second epitaxial semiconductor layer during the forward operation also increases, resulting in a greater effect of achieving the soft recovery of the reverse recovery current. Therefore, it becomes possible in general to easily control a reverse recovery waveform by controlling the impurity concentration and thickness of the second epitaxial semiconductor layer.

In this case, an effect of suppressing the surge voltage becomes greater as a level of achieving the soft recovery of the reverse recovery current is higher. However, too high level of the soft recovery achieved makes the reverse recovery time too long, thereby hindering the speed up of switching operation. Hence, it is desired to control the reverse recovery waveform depending on the switching speed required, by controlling the impurity concentration and thickness of the second epitaxial semiconductor layer.

In a fifth semiconductor device in accordance with the fourth semiconductor device of the present invention, an impurity concentration of the second semiconductor layer at a surface on the side of the first electrode layer is in the range of 1 x 10¹⁵ cm⁻³ to 1 x 10¹⁷cm⁻³ and a thickness of the second semiconductor layer is in the range of 0.1 µm to 3.0 µm.

Preferably, a ratio of a thickness of the second epitaxial semiconductor layer to a thickness of the first epitaxial semiconductor layer is in the range of 1 : 100 to 10 : 1.

In the fifth semiconductor device, since the impurity concentration of the second semiconductor layer at a surface on the side of the first electrode layer is in the range of 1 x 10¹⁵ cm⁻³ to 1 x 10¹⁷ cm⁻³ and the thickness of the second semiconductor layer is in the range of 0.1 µm to 3.0 µm, the effect of the first semiconductor device adds to that of the fourth semiconductor device. Therefore, the reverse recovery electric charges decrease and an increase of the forward voltage therewith is suppressed. Moreover, the soft recovery is achieved, to thereby suppress the surge voltage.

Furthermore, it becomes easier to control the reverse recovery waveform.

The first manufacturing method according to the present invention corresponds to a method of manufacturing the third semiconductor device. According to the present invention, the method comprises steps of: (a) obtaining the first semiconductor layer; (b) forming a semiconductor region of the first conductivity type having the second impurity concentration on the second main surface of the first semiconductor layer to thereby obtain the third semiconductor layer; (c) forming a semiconductor region of the second conductivity type on the first main surface of the first semiconductor layer to thereby obtain the second semiconductor layer; (d) performing an irradiation of corpuscular radiation through the second semiconductor layer to thereby form lattice defects in an interface between the first semiconductor layer and the second semiconductor layer and a region in the vicinity thereof; (e) providing the first electrode layer on the second semiconductor layer before or after the step (d); and (f) providing the second electrode layer on the third semiconductor layer before or after the step (d).

In the first manufacturing method, it is possible to manufacture the third semiconductor device as mentioned above, and more particularly by performing the irradiation of corpuscular radiation through the second semiconductor layer, it is possible to restrict a lattice defect formation region, which exists not only in the stopping range of the corpuscular radiation but also to some extent in a portion through which the corpuscular radiation goes, to the second semiconductor layer and the vicinity of an interface of the first semiconductor layer with the second semiconductor layer, and to hinder a formation of lattice defects in other portions in the semiconductor layers.

The lattice defects are formed in the second semiconductor layer, whereby the injection of electron into the second semiconductor layer is suppressed. On the other hand, the lattice defects are not formed on the reverse side to the second semiconductor layer of the first semiconductor layer, and therefore, the forward voltage does not remarkably increase.

In another aspect of the present invention, the second manufacturing method corresponds to a method of manufacturing the fourth semiconductor device. According to the present invention, the method comprises steps of: (a) obtaining the third semiconductor layer; (b) forming an epitaxial semiconductor region of the first conductivity type having the impurity concentration lower than the impurity concentration of the third semiconductor layer on the third semiconductor layer to thereby obtain the second epitaxial semiconductor layer; (c) forming an epitaxial semiconductor region of the first conductivity type having the impurity concentration lower than the impurity concentration of the second epitaxial semiconductor layer on the second epitaxial semiconductor layer to thereby obtain the first epitaxial semiconductor layer; (d) forming a semiconductor region of the second conductivity type on the first main surface of the first semiconductor layer to thereby obtain the second semiconductor layer; (e) providing the first electrode layer on the second semiconductor layer; and (f) providing the second electrode layer on the third semiconductor layer.

In the second manufacturing method, it is possible to manufacture the fourth semiconductor device as mentioned above.

Accordingly, the first object of the present invention is to suppress an unnecessary accumulation of minority carriers injected to each of the P-type and N-type semiconductor layers during the forward operation, to restrain a rise of the forward voltage, and to provide a semiconductor device in which the amount of reverse recovery electric charges is small.

The second object of the present invention is to achieve the soft recovery of the reverse recovery current to thereby suppress the surge voltage during the reverse recovery, and to provide a semiconductor device in which the number of reverse recovery electric charges is small.

The third object of the present invention is to provide a technique to control the soft recovery waveform with ease.

The fourth object of the present invention is to provide a method of manufacturing the semiconductor device with the above-mentioned features.

These and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a sectional view showing a structure of a semiconductor device in accordance with a first preferred embodiment of the present invention;
Fig. 2 is a schematic diagram showing a distribution of impurity concentration in the direction along a longitudinal section of the semiconductor device of Fig. 1;
Fig. 3 is a graph showing a result of an experiment regarding a relation between a forward voltage and reverse recovery electric charges in the first preferred embodiment as compared with a conventional art;
Fig. 4 is a graph showing reverse recovery current waveforms of the device in accordance with the first preferred embodiment and the conventional art as compared with each other;
Fig. 5 is a sectional view showing a structure of a semiconductor device in accordance with a second preferred embodiment of the present invention;
Fig. 6 is a schematic diagram showing a distribution of impurity concentration in the direction along a longitudinal section of the semiconductor device of Fig. 5;
Fig. 7 is a sectional view showing a structure of a semiconductor device in accordance with a third preferred embodiment of the present invention;
Fig. 8 is a schematic diagram showing a distribution of impurity concentration in the direction along a longitudinal section of the semiconductor device of Fig. 7;
Fig. 9 is a sectional view showing a structure of a semiconductor device in accordance with a fourth preferred embodiment of the present invention;
Fig. 10 is a schematic diagram showing a distribution of impurity concentration in the direction along a longitudinal section of the semiconductor device of Fig. 9;
Fig. 11 is a sectional view showing a structure of a semiconductor device in accordance with a fifth preferred embodiment of the present invention;
Fig. 12 is a schematic diagram showing a distribution of impurity concentration in the direction along a longitudinal section of the semiconductor device of Fig. 11;
Fig. 13 is a sectional view showing a structure of a semiconductor device in accordance with a sixth preferred embodiment of the present invention;
Fig. 14 is a schematic diagram showing a distribution of impurity concentration in the direction along a longitudinal section of the semiconductor device of Fig. 13;
Figs. 15 and 16 are sectional views illustrating a manufacturing process of the semiconductor device in accordance with the first preferred embodiment of the present invention;
Fig. 17 is a sectional view illustrating an example of manufacturing process of the semiconductor device in accordance with the second preferred embodiment of the present invention;
Fig. 18 is a sectional view illustrating another example of manufacturing process of the semiconductor device in accordance with the second preferred embodiment of the present invention;
Fig. 19 is a sectional view illustrating still another example of manufacturing process of the semiconductor device in accordance with the second preferred embodiment of the present invention;
Figs. 20 and 21 are sectional views illustrating a manufacturing process of the semiconductor device in accordance with the third preferred embodiment of the present invention;
Fig. 22 is a sectional view illustrating an example of manufacturing process of the semiconductor device in accordance with the fourth preferred embodiment of the present invention;
Fig. 23 is a sectional view illustrating another example of manufacturing process of the semiconductor device in accordance with the fourth preferred embodiment of the present invention;
Fig. 24 is a sectional view illustrating still another example of manufacturing process of the semiconductor device in accordance with the fourth preferred embodiment of the present invention;
Figs. 25, 26 and 27 are sectional views illustrating a manufacturing process of the semiconductor device in accordance with the fifth preferred embodiment of the present invention;
Fig. 28 is a sectional view illustrating an example of manufacturing process of the semiconductor device in accordance with the sixth preferred embodiment of the present invention;
Fig. 29 is a sectional view illustrating another example of manufacturing process of the semiconductor device in accordance with the sixth preferred embodiment of the present invention;
Fig. 30 is a sectional view illustrating still another example of manufacturing process of the semiconductor device in accordance with the sixth preferred embodiment of the present invention;
Fig. 31 is a sectional view showing an exemplary structure of a conventional semiconductor device; and
Fig. 32 is a schematic diagram showing a distribution of impurity concentration in the direction along a longitudinal section of the semiconductor device of Fig. 31.

### DESCRIPTION OF THE PREFERRED EMBODIMENTS

### 〈 Structures and Characteristics of Semiconductor Devices in The Preferred Embodiments 〉

### 〈 The First Preferred Embodiment 〉

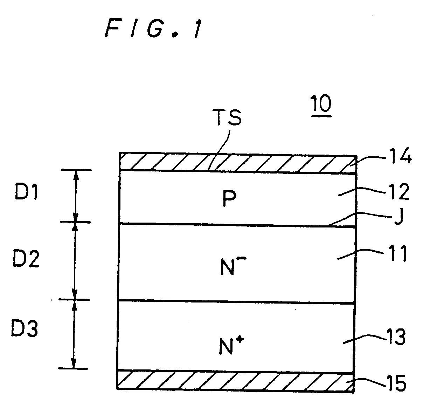

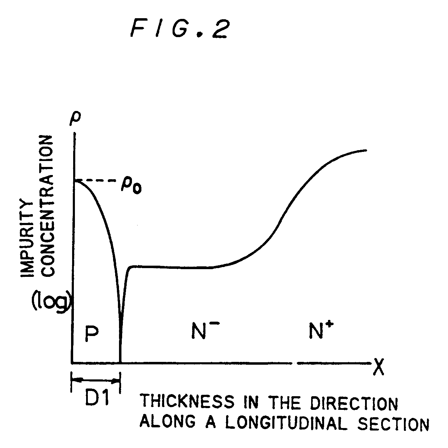

Fig. 1 is a sectional view showing a structure of a high-speed switching diode 10 which is a semiconductor device in accordance with a first preferred embodiment of the present invention. Fig. 2 is a schematic diagram showing a distribution of impurity concentration in the direction along a longitudinal section of the diode 10. This figure illustrates a relation between the thickness X in the direction along the longitudinal section and the impurity concentration ρ of the diode 10 in a semi-logarithmic scale.

As shown in Fig. 1, the diode 10 comprises an N⁻ semiconductor substrate 11 of low impurity concentration, an N⁺ diffused layer 13 of high impurity concentration on the lower main surface of the N⁻ semiconductor substrate 11 and a P diffused layer 12 on the upper main surface of the N⁻ semiconductor substrate 11, wherein an interface J of the N⁻ semiconductor substrate 11 and the P diffused layer 12 is a PN junction area.

The diode 10 further comprises a metal electrode layer 14 formed on the upper surface of the P diffused layer 12 and a metal electrode layer 15 formed on the lower surface of the N⁺ diffused layer 13, both of which are in ohmic contact with the respective diffused layers. The metal electrode layers 14 and 15 correspond to an anode and a cathode, respectively.

In the diode 10, the N⁻ semiconductor substrate 11 has a thickness D2 ranging, for example, from several µm to several hundreds µm and an impurity concentration which is determined in the range, for example, from 1 x 10¹³ cm⁻³ to 1 x 10¹⁵ cm⁻³. The N⁺ diffused layer 13 has a thickness D3 ranging, for example, from several tens µm to several hundreds µm and an impurity surface concentration which is determined in the range, for example, from 1 x 10¹⁷ cm⁻³ to 1 x 10²¹ cm⁻³.

The P diffused layer 12 has an impurity surface concentration ρ 0 (see Fig. 2) in the upper surface thereof, namely the contact area with the metal electrode layer 14, the value of which is adopted in the range of 1 x 10¹⁵ cm⁻³ to 1 x 10¹⁷ cm⁻³.

The reason why the impurity surface concentration of the P diffused layer 12 is determined in the range of 1 x 10¹⁵ cm⁻³ to 1 x 10¹⁷ cm⁻³ is as follows: If the impurity surface concentration of the P diffused layer 12 is over 1 x 10¹⁷ cm⁻³, the number of minority carriers injected from the P diffused layer 12 to the N⁻ semiconductor substrate 11 during a forward operation becomes considerably larger, resulting in a remarkable increase of reverse recovery electric charges. Therefore, the impurity surface concentration of the P diffused layer 12 is desired to be 1 x 10¹⁷ cm⁻³ or under. An effect of decreasing the reverse recovery electric charges becomes greater as the impurity surface concentration of the P diffused layer 12 becomes lower. However, if the impurity surface concentration of the P diffused layer 12 is under 1 x 10¹⁵ cm⁻³, the ohmic contact existing between the metal electrode layer 14 and the P diffused layer 12 is impaired, resulting in a remarkable increase of a forward voltage. Therefore, the impurity surface concentration of the P diffused layer 12 is desired to be 1 x 10¹⁵ cm⁻³ or over.

Further, the P diffused layer 12 has a thickness D1 (see Fig. 1), the value of which is adopted in the range of 0.1 µm to 3.0 µm.

As mentioned above, by making the impurity surface concentration ρ 0 lower and the thickness D1 thinner in the P diffused layer 12 as compared with those in the conventional art, it is possible to suppress an injection of minority carriers (positive holes) from the P diffused layer 12 to the N⁻ semiconductor substrate 11 and an accumulation of minority carries (electrons) in the P diffused layer 12 during the forward operation. Accordingly, an unnecessary accumulation of electric charges is inhibited. In consequence, it becomes possible to decrease the reverse recovery electric charges.

Moreover, since the P diffused layer 12 is thinner, the forward voltage decreases, thereby suppressing an unnecessary rise of the forward voltage.

Furthermore, with the decrease of the reverse recovery electric charges, a peak of the reverse recovery current waveform becomes relatively small, that is, the absolute value of the peak current becomes smaller. Accordingly, a soft recovery is achieved, to thereby decrease a surge voltage.

The thickness of the P diffused layer 12 is determined in the range of 0.1 µm to 3.0 µm, that is, it is thinner than that in the conventional art, so that the number of minority carriers accumulated in the P diffused layer 12 during the forward operation is reduced to thereby inhibit an unnecessary accumulation of charges. In consequence, the reverse recovery charges further decrease.

It also becomes possible to decrease the forward voltage which has been retained by a region having a thickness over 20 µm in the conventional art. The reason why the thickness D1 of the P diffused layer 12 is determined in the range of 0.1 µm to 3.0 µm is as follows: When the P diffused layer 12 has the impurity surface concentration ranging from 1 x 10¹⁵ cm⁻³ to 1 x 10¹⁷ cm⁻³, a region for retaining the forward voltage is enlarged as the P diffused layer 12 becomes thicker, and in particular, the forward voltage remarkably increases when the P diffused layer 12 has a thickness over 3.0 µm. The number of minority carriers accumulated in the P diffused layer 12 during the forward operation also increases, resulting in a remarkable increase of the reverse recovery electric charges. Therefore, the thickness of the P diffused layer 12 is desired to be 3.0 µm or under.

In this case, an effect of decreasing the forward voltage and the reverse recovery electric charges becomes greater as the P diffused layer 12 becomes thinner. However, if the thickness of the P diffused layer 12 is under 0.1 µm, the manufacturing stability and reliability are remarkably deteriorated. Therefore, the thickness of the P diffused layer 12 is desired to be 0.1 µm or over.

Furthermore, the P diffused layer 12 has both the impurity surface concentration ranging from 1 x 10¹⁵ cm⁻³ to 1 x 10¹⁷ cm⁻³ and the thickness ranging from 0.1 µm to 3.0 µm, whereby the reverse recovery electric charges decrease, to accordingly make the peak of the reverse recovery current smaller. In consequence, the soft recovery is achieved, to thereby decrease the surge voltage.

Thus, the P diffused layer 12 which has both the impurity surface concentration ranging from 1 x 10¹⁵ cm⁻³ to 1 x 10¹⁷ cm⁻³ and the thickness ranging from 0.1 µm to 3.0 µm is deemed to be an optimum structure for decreasing the reverse recovery electric charges, suppressing an increase of the forward voltage with the decrease of the reverse recovery electric charges and achieving the soft recovery to thereby suppress the surge voltage. In this case, the impurity surface concentration and the thickness of the P diffused layer 12 should be determined within the optimum ranges as above, respectively, depending on a withstand voltage required. The upper limits of the respective optimum ranges allow the withstand voltage in the kV range.

Furthermore, by diffusing metal such as gold, platinum or the like which acts as lifetime killer in each of the layers 11 to 13, or by irradiating each of the layers 11 to 13 with a radiation of electron beams or the like having high energy, it is also possible to further decrease the number of excess carriers accumulated during the forward operation. In this case, since the P diffused layer 12 which is improved as above is capable of decreasing the forward voltage, a total increase of the forward voltage is restrained to the minimum though the lifetime killer is employed.

The diode 10 having an arrangement where the P-type region and the N-type region are replaced altogether with each other can also ensure the same effect as above.

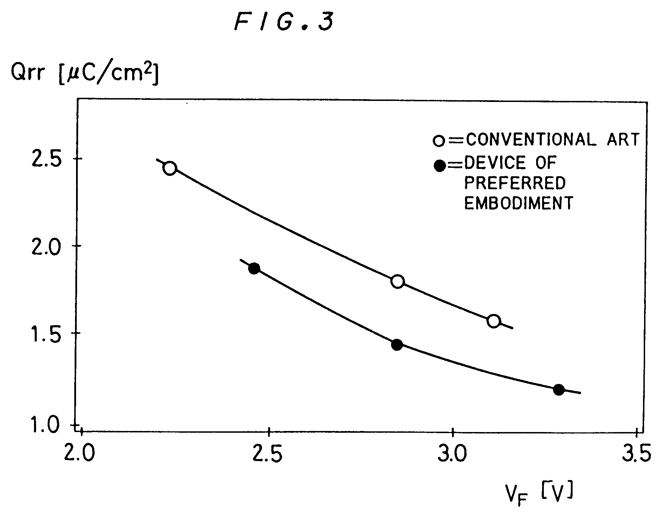

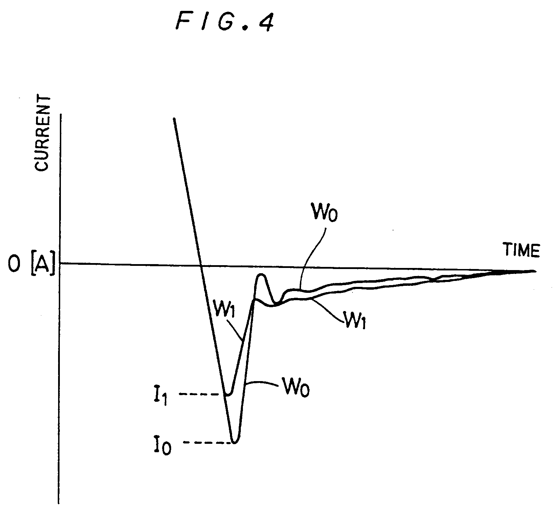

Figs. 3 and 4 show the results of experiments for providing a quantitative verification of the property of the diode 10 as mentioned above.

Fig. 3 is a graph showing a relation between the forward voltage V_{F} and the reverse recovery electric charge Qᵣᵣ in the diode with the withstand voltage of 1400 V. In this figure, solid circles represent the result of the experiment with the device of the preferred embodiment and blank circles represent that with the conventional one. The experiment is conducted under the condition that the forward current is 100 A/cm², the rate of time-varying current is -200 A/cm²/µsec and the temperature is 25 °C.

As can be seen from Fig. 3, in a case of the same forward voltage V_{F}, the reverse recovery electric charge Qᵣᵣ of the device of the preferred embodiment is smaller than that of the conventional one by a decrease of approximately 20 %. From another viewpoint, in a case of the same reverse recovery electric charge Qᵣᵣ, the forward voltage V_{F} of the device of the preferred embodiment is smaller.

Fig. 4 is a graph showing waveforms of the reverse recovery currents. In this figure, a waveform W1 represents the result of the experiment with the device of the preferred embodiment and a waveform W0 represents that with the conventional one. In this experiment, the forward voltage V_{F} is 2.8 V (@ 100 A/cm²).

As can be seen from Fig. 4, the absolute value of the reverse recovery peak current I1 of the device of the preferred embodiment is smaller than that of the reverse recovery peak current I0 of the conventional one by a decrease of approximately 30 %, and the rate of time-varying current of the preferred embodiment dI/dt during the reverse recovery is reduced to approximately 1 / 2.5 of that of the conventional one. Therefore, the soft recovery is achieved, to thereby decrease the surge voltage.

Thus, in the diode 10 in accordance with the preferred embodiment, it is possible to accomplish the reduction of both the reverse recovery electric charges and the forward voltage, and to achieve the soft recovery.

### 〈 The Second Preferred Embodiment 〉

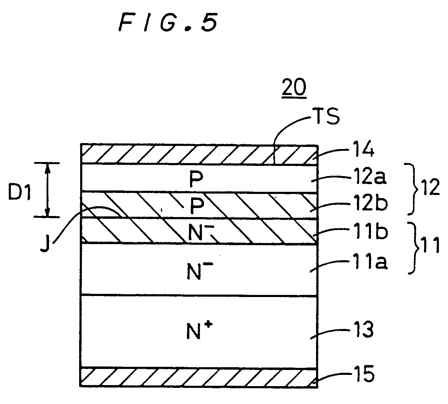

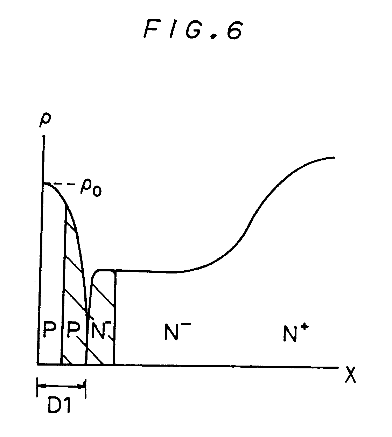

Fig. 5 is a sectional view showing a structure of a diode 20 in accordance with a second preferred embodiment of the present invention. Fig. 6 is a schematic diagram showing a distribution of impurity concentration in the direction along a longitudinal section of the diode 20.

The diode 20 is different from the diode 10 of Fig. 1 in that a region in the vicinity of an interface of the N⁻ semiconductor substrate 11 and the P diffused layer 12, namely a PN junction area J, is irradiated with charged particle beams such as proton beams or the like, to thereby form lattice defects locally restricted which act as lifetime killer.

For this reason, the P diffused layer 12 has a multi-layered structure consisting of a region having the lattice defects 12b and another region having little lattice defects 12a. The N⁻ semiconductor substrate 11 also has a multi-layered structure consisting of a region having the lattice defects 11b and another region having substantially no lattice defects 11a.

In the diode 20, the rest of the structure is the same as the diode 10 in accordance with the first preferred embodiment, and the thickness D1 and the impurity surface concentration ρ 0 of the P diffused layer 12 are determined respectively in conformity to the same standards as applied to the diode 10.

On the same reason as the diode 10, also in the diode 20, it is possible to reduce both the reverse recovery electric charges and the forward voltage, and to achieve the soft recovery.

Moreover, the lattice defect formation region 12b of the P diffused layer 12 decreases the number of minority carriers (electrons) injected from the N⁻ semiconductor substrate 11 to the P diffused layer 12 during the forward operation, and the lattice defect formation region 11b of the N⁻ semiconductor substrate 11 decreases the number of minority carriers (positive holes) injected from P diffused layer 12 to the N⁻ semiconductor substrate 11 during the forward operation. Hence, the effect of decreasing the reverse recovery electric charges and thereby achieving the soft recovery becomes greater than that of the diode 10.

In other words, with the lattice defects formed in the interface of the N⁻ semiconductor substrate 11 and the P diffused layer 12 and the region in the vicinity thereof, namely the lattice defect formation regions 11b and 12b, it is possible to decrease the number of minority carriers injected from the P diffused layer 12 to the N⁻ semiconductor substrate 11 during the forward operation and the number of minority carriers of reverse electric charges injected from the N⁻ semiconductor substrate 11 to the P diffused layer 12 during the forward operation, while the P diffused layer 12 retains the surface concentration at the limit or over to keep in ohmic contact with the metal electrode layer 14.

The diode 20 having an arrangement where the P-type layers (or substrate) and the N-type layers (or substrate) are replaced altogether with each other can also ensure the same effect as above.

### 〈 The Third preferred Embodiment 〉

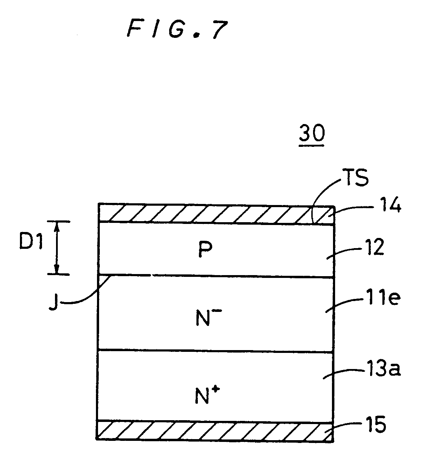

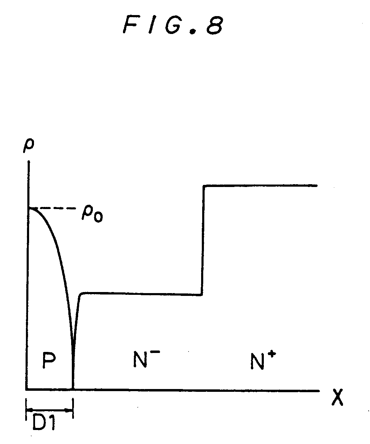

Fig. 7 is a sectional view showing a structure of a diode 30 in accordance with a third preferred embodiment of the present invention. Fig. 8 is a schematic diagram showing a distribution of impurity concentration in the direction along a longitudinal section of the diode 30.

The diode 30 is different from the diode 10 of Fig. 1 in that an N⁺ semiconductor substrate 13a of relatively high impurity concentration is provided instead of the N⁺ diffused layer 13 of Fig. 1 and an N⁻ epitaxial semiconductor layer 11e of relatively low impurity concentration is provided instead of the N⁻ semiconductor substrate 11. In the diode 30, the rest of the structure is the same as the diode 10 in accordance with the first preferred embodiment, and the thickness D1 and the impurity surface concentration ρ 0 of the P diffused layer 12 are determined respectively in conformity to the same standards as applied to the diode 10.

Hence, on the same reason as the diode 10, also in the diode 30, it is possible to reduce both the reverse recovery electric charges and the forward voltage, and to achieve the soft recovery.

Furthermore, it is also possible to further reduce the number of excess carriers accumulated during the forward operation by diffusing metal such as gold, platinum or the like which acts as lifetime killer in each of the layers 12, 11e and 13a, or by irradiating each of the layers 12, 11e and 13a with a radiation of electron beams or the like having high energy. In this case, since the P diffused layer 12 which is improved as shown in the first preferred embodiment is capable of decreasing the forward voltage, a total increase of the forward voltage is restrained to the minimum though the lifetime killer is employed.

The diode 30 having an arrangement where the P-type layers (or substrate) and the N-type layers (or substrate) are replaced altogether with each other can also ensure the same effect as above.

### 〈 The Fourth Preferred Embodiment 〉

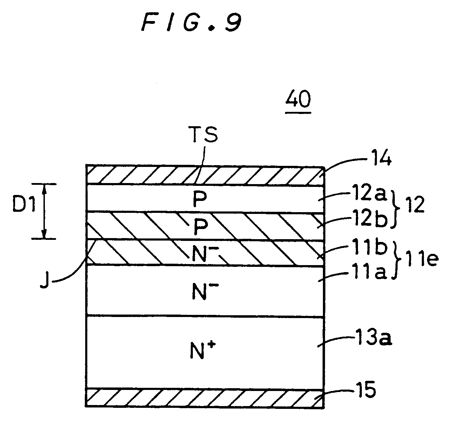

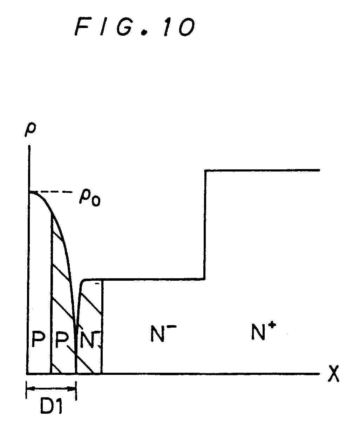

Fig. 9 is a sectional view showing a structure of a diode 40 in accordance with a fourth preferred embodiment of the present invention. Fig. 10 is a schematic diagram showing a distribution of impurity concentration in the direction along a longitudinal section of the diode 40.

The diode 40 is a combination of the diode 20 of Fig. 5 and the diode 30 of Fig. 7 in structure. That is, the diode 40 comprises the N⁺ semiconductor substrate 13a and the N⁻ epitaxial semiconductor layer 11e provided thereon, and includes the lattice defect formation regions 11b and 12b formed by performing an irradiation of charged particle beams.

In the diode 40, the rest of the structure is the same as the diode 10 in accordance with the first preferred embodiment, and the thickness D1 and the impurity surface concentration ρ 0 of the P diffused layer 12 are determined respectively in conformity to the same standards as applied to the diode 10.

Hence, the diode 40 has the same advantages as the diode 20.

The diode 40 having an arrangement where the P-type layers (or substrate) and the N-type layers (or substrate) are replaced altogether with each other can also ensure the same effect as above.

### 〈 The fifth Preferred Embodiment 〉

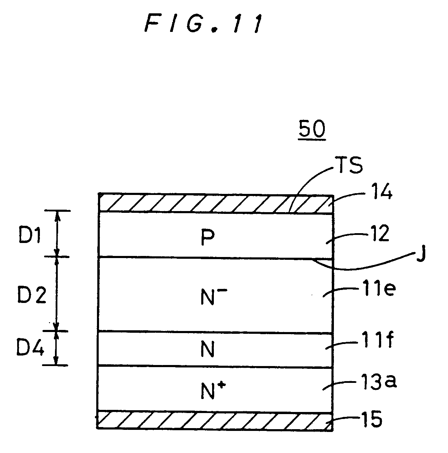

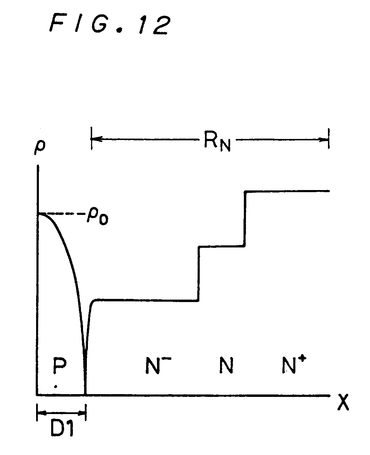

Fig. 11 is a sectional view showing a structure of a diode 50 in accordance with a fifth preferred embodiment of the present invention. Fig. 12 is a schematic diagram showing a distribution of impurity concentration in the direction along a longitudinal section of the diode 50.

In the diode 50, an N epitaxial buffer layer 11f is further provided between the N⁻ epitaxial semiconductor layer 11e and the N⁺ semiconductor substrate 13a of the diode 30 shown in Fig. 7. The impurity concentration of the N epitaxial buffer layer 11f is higher than that of the N⁻ epitaxial semiconductor layer 11e, and is lower than that of the N⁺ semiconductor substrate 13a.

The N epitaxial buffer layer 11f has a thickness D4, and a ratio of the thickness D4 of the N epitaxial buffer layer 11f to the thickness D2 of the N⁻ epitaxial semiconductor layer 11e, D4 : D2, is desired to be in the range of 1 : 100 to 10 : 1.

In the diode 50, the rest of the structure is the same as the diode 10 in accordance with the first preferred embodiment, and the thickness D1 and the impurity surface concentration ρ 0 of the P diffused layer 12 are determined respectively in conformity to the same standards as applied to the diode 10.

Fig. 12 clearly shows that the N-type impurity concentration in the diode 50 has a distribution of multi-stage stepped structure, and the impurity concentration becomes higher step by step as a distance from the P diffused layer 12 increases. Hence, it is possible to vary the distribution of impurity concentration in the N-type semiconductor region R_{N} (shown in Fig. 12) diversely by changing each impurity concentration and thickness of the N⁻ epitaxial semiconductor layer 11e, the N epitaxial buffer layer 11f and the N⁺ semiconductor substrate 13a. Accordingly, it becomes easier to control the distribution of impurity concentration of the region in the vicinity of the interface between the N⁻ epitaxial semiconductor layer 11e and the N⁺ semiconductor substrate 13a by controlling the impurity concentration and thickness of the N epitaxial buffer layer 11f. In consequence, it is possible to easily control a soft recovery waveform of the reverse recovery current. In order to enhance the level of the soft recovery, the impurity concentration of the N epitaxial buffer layer 11f is set low and the thickness thereof is set large to increase the number of excess carriers to be accumulated in the N epitaxial buffer layer 11f during the forward operation.

In this case, an effect of suppressing a surge voltage during the reverse recovery operation becomes greater as the level of achieving the soft recovery is higher. However, too high level of the soft recovery achieved makes the reverse recovery time too long, thereby hindering the speed up of switching operation. Accordingly, it is desired to control the reverse recovery waveform depending on the switching speed required, by controlling the impurity concentration and thickness of the N epitaxial buffer layer 11f.

Other advantages of the diode 50 are the same as the diode 30.

Furthermore, it is also possible to further reduce the number of excess carriers accumulated during the forward operation by diffusing metal such as gold, platinum or the like which acts as lifetime killer in each of the layers 11e, 11f, 12, and 13a, or by irradiating each of the layers 11e, 11f, 12, and 13a with a radiation of electron beams or the like having high energy. In this case, since the P diffused layer 12 which is improved as shown in the first preferred embodiment is capable of decreasing the forward voltage, a total increase of the forward voltage is restrained to the minimum though the lifetime killer is employed.

The diode 50 having an arrangement where the P-type layers (or substrate) and the N-type layers (or substrate) are replaced altogether with each other can also ensure the same effect as above.

### 〈 The Sixth Preferred Embodiment 〉

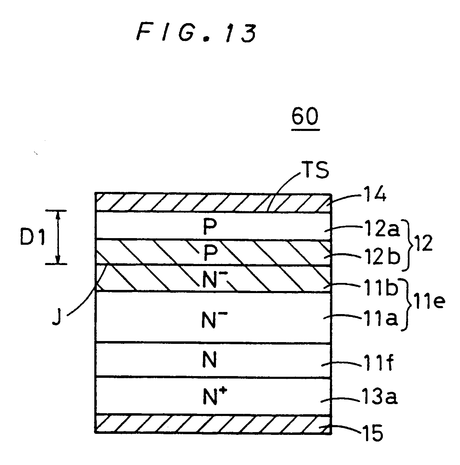

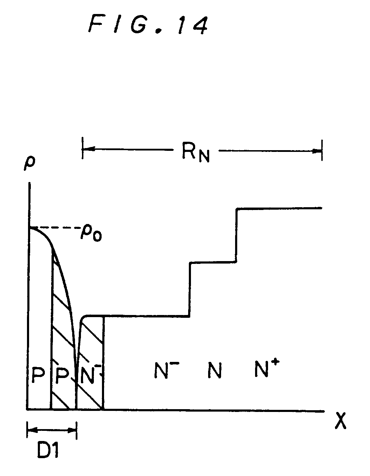

Fig. 13 is a sectional view showing a structure of a diode 60 in accordance with a sixth preferred embodiment of the present invention. Fig. 14 is a schematic diagram showing a distribution of impurity concentration in the direction along a longitudinal section of the diode 60.

The diode 60 is a combination of the diode 20 of Fig. 5 and the diode 50 of Fig. 11 in structure. That is, the diode 60 comprises the N⁻ epitaxial semiconductor layer 11e, N⁺ semiconductor substrate 13a and the N epitaxial buffer layer 11f, and includes the lattice defect formation regions 11b and 12b formed by performing an irradiation of charged particle beams.

In the diode 60, the rest of the structure is the same as the diode 10 in accordance with the first preferred embodiment, and the thickness D1 and the impurity surface concentration ρ 0 of the P diffused layer 12 are determined respectively in conformity to the same standards as applied to the diode 10.

Hence, the diode 60 combines the advantages of the diodes 20 and 50.

The diode 60 having an arrangement where the P-type layers (or substrate) and the N-type layers(or substrate) are replaced altogether with each other can also ensure the same effect as above.

### 〈 Modification 〉

(1) In the diodes 50 and 60, it is shown that the distribution of impurity concentration in the N-type region R_{N} is of three-stage stepped structure, but the distribution may be of four-stage stepped structure or more.
(2) The present invention can be applied to any similar semiconductor device which has PN junctions as well as the diode.

### 〈 Methods of Manufacturing Devices in The Preferred Embodiments 〉

### 〈 The First Preferred Embodiment 〉

The diode 10 of Fig. 1 can be manufactured as described below.

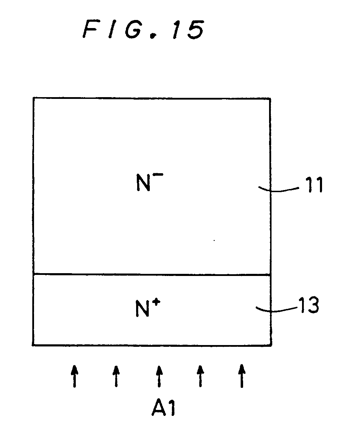

First of all, an N⁻ semiconductor substrate 11 shown in Fig. 15 is prepared, and then N-type impurities are diffused therein from its lower main surface side as indicated by an arrow A1, to thereby form an N⁺ diffused layer 13.

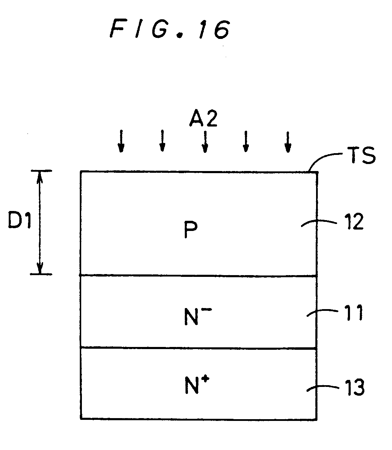

Next, as shown in Fig. 16, P-type impurities are diffused in a part of the N⁻ semiconductor substrate 11 from the direction indicated by an arrow A2 to form a P diffused layer 12. In diffusing the P-type impurities, a diffusion length D1 should be in the range of 0.1 µm to 3.0 µm, and a diffusion concentration should be determined so that an impurity surface concentration in an upper main surface TS of the P diffused layer 12 may be in the range of 1 x 10¹⁵ cm⁻³ to 1 x 10¹⁷ cm⁻³.

Then, a metal electrode 14 (shown in Fig. 1) is provided on the upper main surface of the P diffused layer 12 and a metal electrode 15 (shown in Fig. 1) is provided on the lower main surface of the N⁺ diffused layer 13, thus obtaining the structure of the diode 10.

### 〈 The Second Preferred Embodiment 〉

In a process of manufacturing the diode 20 of Fig. 5, the first half is the same as the process of Figs. 15 and 16 in the above-described manufacturing process of the diode 10.

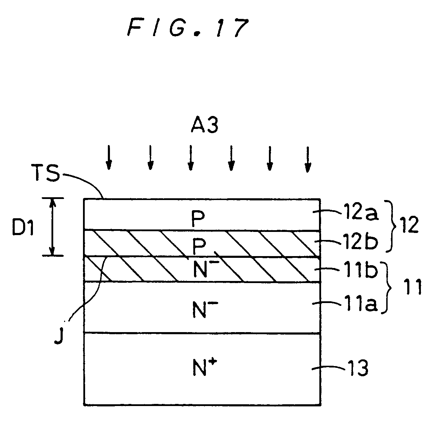

Next, as indicated by an arrow A3 in Fig. 17, an irradiation of charged particle beams such as proton beams or the like is performed from the upper main surface side of the P diffused layer 12 and through the P diffused layer 12 to form lattice defects which act as lifetime killer locally restricted in the vicinity of the interface between the N⁻ semiconductor substrate 11 and the P diffused layer 12, namely a PN junction area J.

The irradiation of corpuscular radiation as above can restrict a lattice defect formation region, which exists not only in the stopping range of the corpuscular radiation but also to some extent in a portion through which the corpuscular radiation goes, to the P diffused layer 12 and the vicinity of the PN junction area J of the P diffused layer 12 and the N⁻ semiconductor substrate 11, and can hinder a formation of lattice defects in other portions of the semiconductor layers.

The lattice defects are formed in the P diffused layer 12, whereby the injection of electron into the P diffused layer 12 is suppressed. On the other hand, the lattice defects are not formed on the reverse side to the P diffused layer 12 of the N⁻ semiconductor substrate, and therefore, the forward voltage does not remarkably increase.

Therefore, the P diffused layer 12 has a multi-layered structure consisting of a region 12b having lattice defects and a region 12a having little lattice defects as compared with the region 12b. The N⁻ semiconductor substrate 11 also has a multi-layered structure consisting of a region 11b having lattice defects and a region 11a having substantially no lattice defects.

Then, a metal electrode 14 (shown in Fig. 5) is provided on the upper main surface of the P diffused layer 12 and a metal electrode 15 (shown in Fig. 5) is provided on the lower main surface of the N⁺ diffused layer 13, thus obtaining the structure of the diode 20.

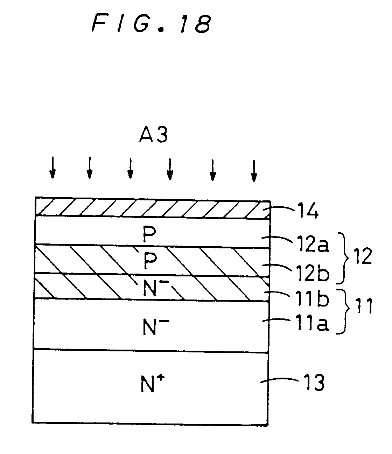

The irradiation of charged particle beams may be performed after providing the metal electrode 14. Fig. 18 illustrates that the irradiation of charged particle beams is performed through the metal electrode 14 and the P diffused layer 12 after providing the metal electrode 14.

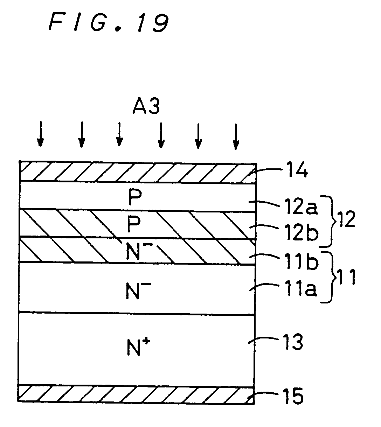

Further, Fig. 19 illustrates that the irradiation of charged particle beams is performed through the metal electrode 14 and the P diffused layer 12 after providing the metal electrodes 14 and 15.

### 〈 The Third Preferred Embodiment 〉

The diode 30 of Fig. 7 can be manufactured as described below.

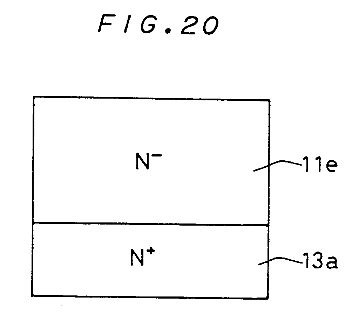

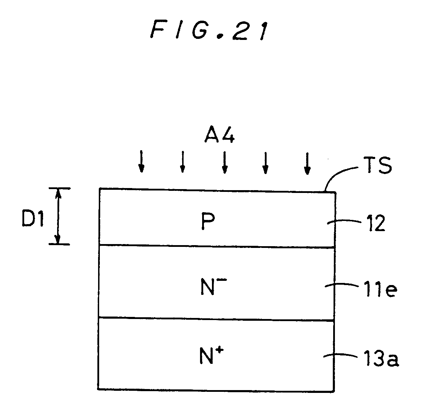

First of all, an N⁺ semiconductor substrate 13a shown in Fig. 20 is prepared, and then an N⁻ epitaxial semiconductor layer 11e is grown on an upper main surface thereof. After that, P-type impurities are diffused in an upper portion of the N⁻ epitaxial semiconductor layer 11e as indicated by an arrow A4 in Fig. 21, to thereby form a P diffused layer 12. In diffusing the P-type impurities, a diffusion length D1 should be in the range of 0.1 µm to 3.0 µm, and a diffusion concentration should be determined so that an impurity surface concentration in an upper main surface TS of the P diffused layer 12 may be in the range of 1 x 10¹⁵ cm⁻³ to 1 x 10¹⁷ cm⁻³.

Then, a metal electrode 14 (shown in Fig. 7) is provided on the upper main surface of the P diffused layer 12 and a metal electrode 15 (shown in Fig. 7) is provided on the lower main surface of the N⁺ semiconductor substrate 13a, thus obtaining the structure of the diode 30.

### 〈 The Fourth Preferred Embodiment 〉

In a process of manufacturing the diode 40 of Fig. 9, the first half is the same as the process of Figs. 20 and 21 in the above-described manufacturing process of the diode 30.

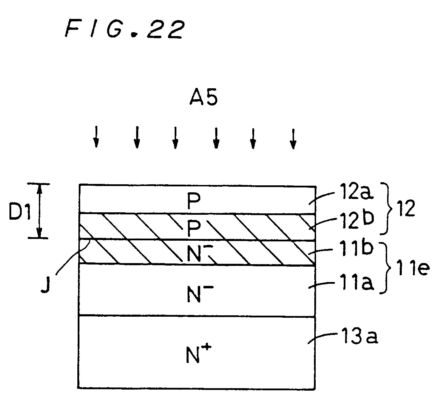

Next, as indicated by an arrow A5 in Fig. 22, an irradiation of charged particle beams such as proton beams or the like is performed from the upper main surface side of the P diffused layer 12 and through the P diffused layer 12 to form lattice defects which act as lifetime killer locally restricted in the vicinity of the interface between the N⁻ epitaxial semiconductor layer 11e and the P diffused layer 12, namely a PN junction area J.

With the irradiation as mentioned above, the P diffused layer 12 has a multi-layered structure consisting of a region 12b having lattice defects and a region 12a having little lattice defects as compared with the region 12b. The N⁻ epitaxial semiconductor layer 11e also has a multi-layered structure consisting of a region 11b having lattice defects and a region 11a having substantially no lattice defects.

Then, a metal electrode 14 (shown in Fig. 9) is provided on the upper main surface of the P diffused layer 12 and a metal electrode 15 (shown in Fig. 9) is provided on the lower main surface of the N⁺ semiconductor substrate 13a, thus obtaining the structure of the diode 40.

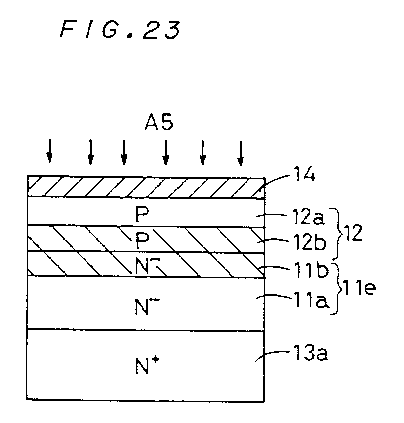

The irradiation of charged particle beams may be performed after providing the metal electrode 14. Fig. 23 illustrates that the irradiation of charged particle beams is performed through the metal electrode 14 and the P diffused layer 12 after providing the metal electrode 14.

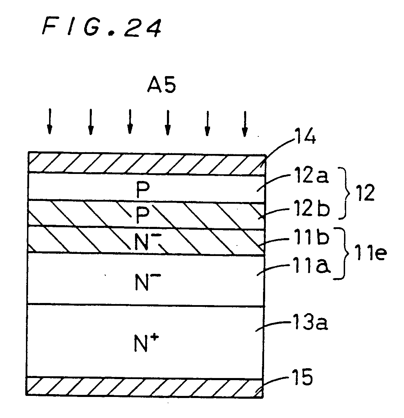

Further, Fig. 24 illustrates that the irradiation of charged particle beams is performed through the metal electrode 14 and the P diffused layer 12 after providing the metal electrodes 14 and 15.

### 〈 The fifth Preferred Embodiment 〉

The diode 50 of Fig. 11 can be manufactured as described below.

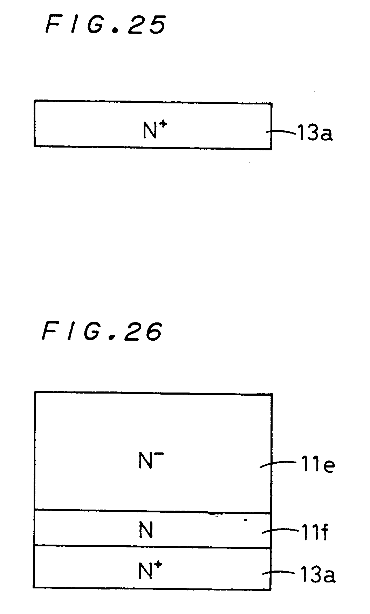

First of all, an N⁺ semiconductor substrate 13a shown in Fig. 25 is prepared, and then an N epitaxial buffer layer 11f is grown on an upper main surface thereof (shown in Fig. 26). Further, an N⁻ epitaxial semiconductor layer 11e is grown on the N epitaxial buffer layer 11f.

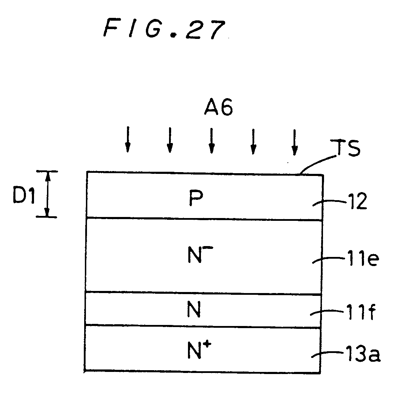

After that, P-type impurities are diffused in an upper portion of the N⁻ epitaxial semiconductor layer 11e as indicated by an arrow A6 in Fig. 27, to thereby form a P diffused layer 12. In diffusing the P-type impurities, a diffusion length D1 should be in the range of 0.1 µm to 3.0 µm, and a diffusion concentration should be determined so that an impurity surface concentration in an upper main surface TS of the P diffused layer 12 may be in the range of 1 x 10¹⁵ cm⁻³ to 1 x 10¹⁷ cm⁻³.

Then, a metal electrode 14 (shown in Fig. 11) is provided on the upper main surface of the P diffused layer 12 and a metal electrode 15 (shown in Fig. 11) is provided on the lower main surface of the N⁺ semiconductor substrate 13a, thus obtaining the structure of the diode 50.

### 〈 The Sixth Preferred Embodiment 〉

In a process of manufacturing the diode 60 of Fig. 13, the first half is the same as the process of Figs. 25 to 27 in the above-described manufacturing process of the diode 50.

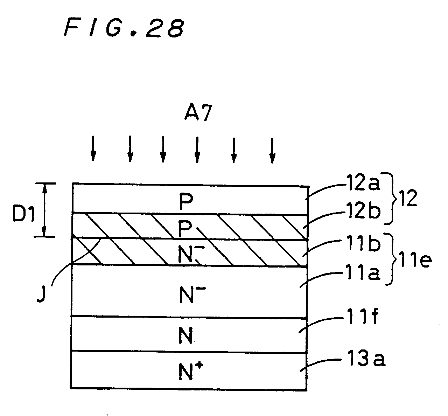

Next, as indicated by an arrow A7 in Fig. 28, an irradiation of charged particle beams such as proton beams or the like is performed from the upper main surface side of the P diffused layer 12 and through the P diffused layer 12 to form lattice defects which act as lifetime killer locally restricted in the vicinity of the interface between the N⁻ epitaxial semiconductor layer 11e and the P diffused layer 12, namely a PN junction area J.

With the irradiation as mentioned above, the P diffused layer 12 has a multi-layered structure consisting of a region 12b having lattice defects and a region 12a having little lattice defects as compared with the region 12b. The N⁻ epitaxial semiconductor layer 11e also has a multi-layered structure consisting of a region 11b having lattice defects and a region 11a having substantially no lattice defects.

Then, a metal electrode 14 (shown in Fig. 13) is provided on the upper main surface of the P diffused layer 12 and a metal electrode 15 (shown in Fig. 13) is provided on the lower main surface of the N⁺ semiconductor substrate 13a, thus obtaining the structure of the diode 60.

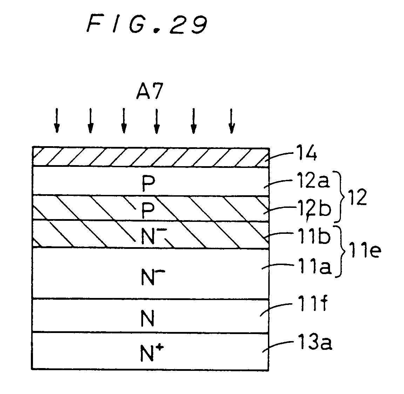

The irradiation of charged particle beams may be performed after providing the metal electrode 14. Fig. 29 illustrates that the irradiation of charged particle beams is performed through the metal electrode 14 and the P diffused layer 12 after providing the metal electrode 14.

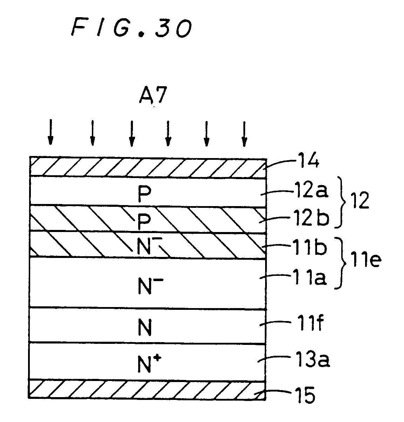

Further, Fig. 30 illustrates that the irradiation of charged particle beams is performed through the metal electrode 14 and the P diffused layer 12 after providing the metal electrodes 14 and 15.

While the invention has been shown and described in detail, the foregoing description is in all aspects illustrative and not restrictive. It is therefore understood that numerous modifications and variations can be devised without departing the scope of the invention.

## Claims

1. A semiconductor device, comprising:
(a) a first semiconductor layer of a first conductivity type including first and second main surfaces and having a first impurity concentration;
(b) a second semiconductor layer of a second conductivity type provided on said first main surface of said first semiconductor layer;
(c) a third semiconductor layer of the first conductivity type provided on said second main surface of said first semiconductor layer and having a second impurity concentration higher than said first impurity concentration;
(d) a first electrode layer being in electric contact with said second semiconductor layer; and
(e) a second electrode layer being in electric contact with said third semiconductor layer, and wherein
an impurity concentration of said second semiconductor layer at a surface on the side of said first electrode layer is in the range of 1 x 10¹⁵ cm⁻³ to 1 x 10¹⁷ cm⁻³.

2. The semiconductor device of claim 1, wherein
lattice defects are formed in an interface between said first semiconductor layer and said second semiconductor layer and a region in the vicinity thereof.

3. The semiconductor device of claim 1, wherein
a thickness of said second semiconductor layer is in the range of 0.1 µm to 3.0 µm.

4. The semiconductor device of claim 3, wherein
lattice defects are formed in an interface between said first semiconductor layer and said second semiconductor layer and a region in the vicinity thereof.

5. A semiconductor device, comprising:
(a) a first semiconductor layer of a first conductivity type including first and second main surfaces and having a first impurity concentration;
(b) a second semiconductor layer of a second conductivity type provided on said first main surface of said first semiconductor layer;
(c) a third semiconductor layer of the first conductivity type provided on said second main surface of said first semiconductor layer and having a second impurity concentration higher than said first impurity concentration;
(d) a first electrode layer being in electric contact with said second semiconductor layer; and
(e) a second electrode layer being in electric contact with said third semiconductor layer, and wherein
lattice defects are formed in an interface between said first semiconductor layer and said second semiconductor layer and a region in the vicinity thereof.

6. A semiconductor device, comprising:
(a) a first semiconductor layer of a first conductivity type including first and second main surfaces;
(b) a second semiconductor layer of a second conductivity type provided on said first main surface of said first semiconductor layer;
(c) a third semiconductor layer of the first conductivity type provided on said second main surface of said first semiconductor layer and having an impurity concentration higher than an impurity concentration of said first semiconductor layer;
(d) a first electrode layer being in electric contact with said second semiconductor layer; and
(e) a second electrode layer being in electric contact with said third semiconductor layer, and wherein
said first semiconductor layer further includes:
(a-1) a first epitaxial semiconductor layer being in electric contact with said second semiconductor layer and having an impurity concentration lower than said impurity concentration of said third semiconductor layer; and
(a-2) a second epitaxial semiconductor layer provided between said first epitaxial semiconductor layer and said third semiconductor layer and having an impurity concentration higher than said impurity concentration of said first epitaxial semiconductor layer and lower than said impurity concentration of said third semiconductor layer.

7. The semiconductor device of claim 6, wherein
an impurity concentration of said second semiconductor layer at a surface on the side of said first electrode layer is in the range of 1 x 10¹⁵ cm⁻³ to 1 x 10¹⁷ cm⁻³ and a thickness of said second semiconductor layer is in the range of 0.1 µm to 3.0 µm.

8. The semiconductor device of claim 7, wherein
a ratio of a thickness of said second epitaxial semiconductor layer to a thickness of said first epitaxial semiconductor layer is in the range of 1 : 100 to 10 : 1.

9. A method of manufacturing a semiconductor device, wherein
said semiconductor device comprises: a first semiconductor layer of a first conductivity type including first and second main surfaces and having a first impurity concentration; a second semiconductor layer of a second conductivity type provided on said first main surface of said first semiconductor layer; a third semiconductor layer of the first conductivity type provided on said second main surface of said first semiconductor layer and having a second impurity concentration higher than said first impurity concentration; a first electrode layer being in electric contact with said second semiconductor layer; and a second electrode layer being in electric contact with said third semiconductor layer,
said method comprising steps of:
(a) obtaining said first semiconductor layer;
(b) forming a semiconductor region of the first conductivity type having said second impurity concentration on said second main surface of said first semiconductor layer to thereby obtain said third semiconductor layer;
(c) forming a semiconductor region of the second conductivity type on said first main surface of said first semiconductor layer to thereby obtain said second semiconductor layer;
(d) performing an irradiation of corpuscular radiation through said second semiconductor layer to thereby form lattice defects in an interface between said first semiconductor layer and said second semiconductor layer and a region in the vicinity thereof;
(e) providing said first electrode layer on said second semiconductor layer before or after said step (d); and
(f) providing said second electrode layer on said third semiconductor layer before or after said step (d).

10. A method of manufacturing a semiconductor device, wherein
said semiconductor device comprises: a first semiconductor layer of a first conductivity type including first and second main surfaces; a second semiconductor layer of a second conductivity type provided on said first main surface of said first semiconductor layer; a third semiconductor layer of the first conductivity type provided on said second main surface of said first semiconductor layer; a first electrode layer being in electric contact with said second semiconductor layer; and a second electrode layer being in electric contact with said third semiconductor layer, and wherein
said first semiconductor layer further includes: a first epitaxial semiconductor layer exposed on said first main surface and having a first impurity concentration lower than an impurity concentration of said third semiconductor layer; and a second epitaxial semiconductor layer exposed on said second main surface and having a second impurity concentration lower than said impurity concentration of said third semiconductor layer and higher than said first impurity concentration,
said method comprising steps of:
(a) obtaining said third semiconductor layer;
(b) forming an epitaxial semiconductor region of the first conductivity type having said second impurity concentration on said third semiconductor layer to thereby obtain said second epitaxial semiconductor layer;
(c) forming an epitaxial semiconductor region of the first conductivity type having said first impurity concentration on said second epitaxial semiconductor layer to thereby obtain said first epitaxial semiconductor layer;
(d) forming a semiconductor region of said second conductivity type on said first main surface of said first semiconductor layer to thereby obtain said second semiconductor layer;
(e) providing said first electrode layer on said second semiconductor layer; and
(f) providing said second electrode layer on said third semiconductor layer.
